(19) Europäisches Patentamt

European Patent Office

Office européen des brevets

(11) **EP 0 805 551 A1**

(12) **EUROPEAN PATENT APPLICATION**

(43) Date of publication:
05.11.1997 Bulletin 1997/45

(51) Int. Cl.⁶: **H03F 3/193**

(21) Application number: 96106855.8

(22) Date of filing: 30.04.1996

(84) Designated Contracting States:
DE FR GB

(71) Applicant:
MATSUSHITA ELECTRIC INDUSTRIAL CO., LTD.
Kadoma-shi, Osaka 571 (JP)

(72) Inventor: Itoh, Junji
Hirakata-shi, Osaka 573 (JP)

(74) Representative:
Grünecker, Kinkeldey,
Stockmair & Schwanhäusser
Anwaltssozietät
Maximilianstrasse 58
80538 München (DE)

(54) **Semiconductor circuit**

(57) Between a power source and a ground, a first FET which is formed by an FET having a relatively shallow threshold value and a second FET which is formed by a depression type FET having a relatively deep threshold value are arranged in series to each other in this order from the ground. Further, an input matching circuit is disposed between a gate of the first FET and an input terminal, and an output matching circuit is disposed between a drain of the second FET and an output terminal. Utilizing a fact that an operation current of an amplifier is set by a drain current of the first FET, which has a shallow threshold value, at a 0-bias point, a power source voltage is decreased. An amplifier and a frequency conversion circuit operating at a low power source voltage are obtained without degrading a distortion characteristic.

F I G .1

EP 0 805 551 A1

## Description

BACKGROUND OF THE INVENTION

The present invention relates to a receiver circuit for receiving a high frequency signal, and particularly, to a receiver circuit which is suitable to a radio machine for communication with a low voltage operation.

Recent years have seen reductions in the size, the weight and the price of a communication machine such as a portable telephone radio machine. An efficient method to reduce the size of a portable machine is to decrease consumption power which is taken up by parts and to fabricate batteries which are to be mounted as small as possible. To realize this, such a semiconductor circuit is widely used which uses a gallium arsenide (hereinafter referred to as GaAs) Schottky gate field effective transistor (hereinafter referred to MESFET) which requires a low consumption current and has an excellent high frequency characteristic.

In general, a circuit which utilizes a GaAsMESFET which takes up a low consumption current and has an excellent high frequency characteristic, in particular, uses a method of controlling a current by means of a negative gate bias voltage, so that a source voltage is set higher than a gate voltage and only one power source circuit provides this negative voltage between a gate and a source.

Now, an example of a conventional receiver circuit which incorporates a GaAsMESFET will be described with reference to drawings.

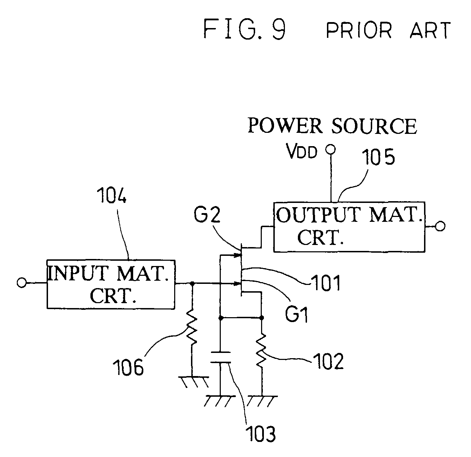

Fig. 9 is an electric circuitry diagram showing a structure of an amplifier which is incorporated in a receiver circuit and which uses a conventional GaAs-MESFET. In Fig. 9, denoted at 101 is a dual gate type FET which is formed by a depression type FET and which includes two gates, i.e., a first gate G1 and a second gate G2. Denoted at 102 is a bias resistor element, denoted at 103 is a bypass capacitor for grounding a high frequency signal, denoted at 104 is an input matching circuit, and denoted at 105 is an output matching circuit. Denoted at 106 is a resistor element whose resistance value is a few k ohms. Through the resistor element 106, the first gate G1 of the FET 101 is grounded. The second gate G2 of the FET 101 is connected to the source, to thereby improve separation from the output side toward an input.

In the following, an operation of the amplifier circuit which is structured as above will be described.

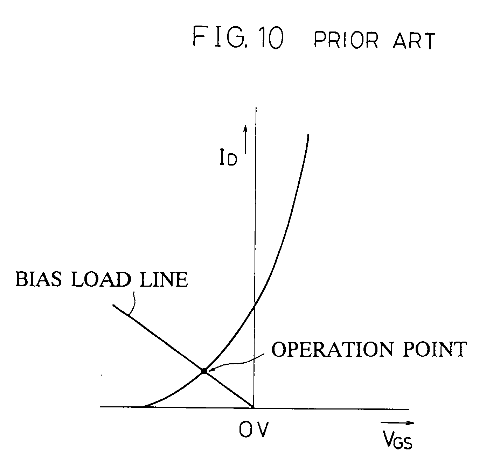

An operation current of the FET 101 is set by a threshold value of the FET 101 and a bias resistance of the bias resistor element 102. Fig. 10 diagrammatically shows operation points of the FET 101. A horizontal axis shows a gate (first gate G1)-source voltage $V_{GS}$, while a vertical axis shows a drain current $I_D$. In Fig. 10, a voltage $V_{GS}$ at an intersection of a bias load line and an $I_D$-$V_{GS}$ characteristic curve of the FET 101 is a gate bias. The drain current $I_D$ at this point is an operation current. However, since a potential of the first gate G1 is a potential of 0V, i.e., a ground potential in reality, when the source voltage of the FET 101 is a positive potential, a negative gate bias voltage is applied. The FET 101 having such a structure as described above amplifies an input signal (high frequency signal) which is supplied to the first gate G1 through an input matching circuit 104, and outputs the same to the drain. The input signal is thereafter outputted to outside through an matching circuit 105.

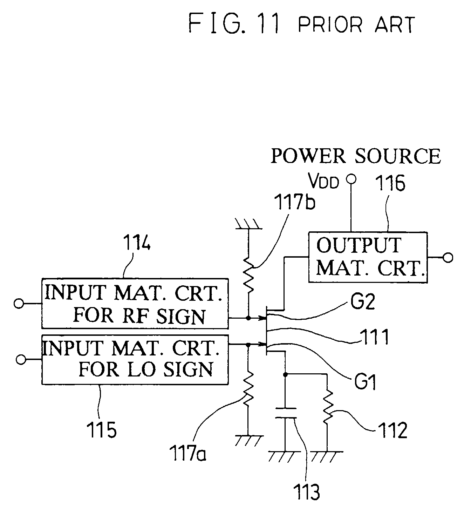

Meanwhile, Fig. 11 is an electric circuitry diagram showing a frequency convertor circuit which is incorporated in the receiver circuit and which uses a conventional GaAsMESFET.

In Fig. 11, denoted at 111 is a dual gate type FET which is formed by a depression type FET and which includes a first gate G1 and a second gate G2. Denoted at 112 is a bias resistor element, denoted at 113 is a bypass capacitor for grounding a high frequency signal, denoted at 114 is an input matching circuit for signal to be frequency-converted (RF signal in the figure), and denoted at 115 is an input matching circuit for local oscillation signal (LO signal in the figure). Denoted at 116 an output matching circuit. Denoted at 117a and 117b are resistor elements each having a resistance value of a few k ohms. Through the resistor elements 117a and 117b, the first gate G1 and the second gate G2 are respectively grounded.

Now, an operation of the frequency conversion circuit which is structured as above will be described.

An operation current of the FET 111 is determined by the same effect as that which has been described in relation to the amplifier of Fig. 9. A signal to be frequency-converted is supplied to the first gate G1 through the input matching circuit 114 for signal to be frequency-converted, while a local oscillation signal is supplied to the second gate G2 through the input matching circuit for local oscillation signal. The signal to be frequency-converted is frequency-converted by the local oscillation signal at the dual gate FET 111. The output signal which is frequency-converted is outputted at the drain, through the output matching circuit 116.

However, in such a circuitry structure as described above, it is necessary to supply a negative bias to the gate so as to set an operation point which ensures a smooth operation, and therefore, to realize this, the gate voltage is set at 0V and the source voltage of the FET is set positive. On the other hand, to reduce a distortion between the input signal and the output signal in the FET, the threshold value cannot be set to low. That is, to ensure a smooth operation in the FET, the drain voltage needs be higher than the source voltage by a sufficient amount. Hence, unless the drain voltage is set high so that the source voltage has a positive value, it is possible that the FET will not smoothly operate.

In other words, there is a limit in reducing a power source voltage in a high frequency amplifier circuit which includes a dual gate type FET of such a conventional structure as described above or in a frequency conversion circuit.

## SUMMARY OF THE INVENTION

An object of the present invention is to provide for a semiconductor circuit which functions as an amplifier or a frequency conversion circuit in which a power source voltage is decreased while maintaining an excellent distortion characteristic of an FET.

A first semiconductor circuit according to the present invention is a semiconductor circuit which is formed by arranging a first FET and a second FET between a ground and a power source in series to each other in this order from the ground, wherein the first FET includes a gate which receives an input signal, a source which is connected to the ground, and a drain, the first FET having a relatively shallow threshold value, the second FET includes a gate which is connected to a source of the second FET, the source, and a drain which is connected to the power source to serve as a signal output part, the second FET having a threshold value which is deeper than the threshold value of the first FET, and the semiconductor circuit serves as an amplifier which amplifies a signal which is inputted at the gate of the first FET and outputs the signal at the drain of the second FET.

In the structure of the first semiconductor circuit, since the second FET is formed by an FET which has a relatively large threshold value,' the second FET has an extremely resistance value. Hence, when a power source voltage is applied between the drain of the second FET and the source of the first FET, voltage drop after the second FET is small so that the power source voltage is applied mostly to the first FET whose threshold value is small. This allows to decrease the power source voltage which is necessary to operate the first FET, and to maintain a gain of an output signal relative to an input signal high.

The first FET and the second FET within the first semiconductor circuit may be dual gate type FETs which have common source and drain, or the sources and the drains of the first FET and the second FET may be separate from each other.

The first semiconductor circuit may have a structure in which the source of the first FET is connected directly to the ground.

Since such a structure allows a source potential of the first FET to become zero, even if the power source voltage is extremely small, it is possible to guarantee a voltage which is necessary to smoothly operate the first FET. In addition, since the source of the first FET is connected directly to the ground, even when an unnecessary signal might flow to the gate of the first FET through the drain of the second FET from the output, the unnecessary signal is bypassed to the ground via the gate of the second FET. Thus, a separation characteristic for separating an output from an input is maintained excellent.

The first semiconductor circuit may have a structure in which the threshold value of the first FET is approximately zero and the second FET is a depression type FET which has a relatively deep threshold value.

In such a structure, since the threshold value of the first FET is approximately zero and the source of the first FET is connected directly to the ground, an operation current of the first FET is set by a drain current at this 0-bias point. Hence, the power source voltage as it is becomes a voltage between the drain of the second FET and the source of the first FET, and the power source voltage can be further decreased.

The first semiconductor circuit may have a structure in which the gate of the first FET is connected to the ground through a resistor.

In such a structure, since a high frequency signal which is inputted at the gate of the first FET does not almost flow into the ground through the resistor, a gate potential of the first FET is maintained almost as zero. This makes it possible to maintain a low power source voltage. Further, connection through the resistor effectively prevents a high frequency signal from leaking to the ground side.

The first semiconductor circuit may further comprise an input matching circuit which is disposed before the gate of the first FET to match input signals; and an output matching circuit which is disposed after the drain of the second FET to match output signals.

In such a structure, since high frequency signals are matched within the semiconductor circuit, it is possible to match high frequency signals without forming a matching circuit externally to the semiconductor circuit.

The first semiconductor circuit may have a structure in which the first FET and the second FET are MESFETs which are formed on a compound semiconductor substrate.

With such a structure, it is possible to form a semiconductor circuit which has an excellent frequency characteristic.

The first semiconductor circuit may have a structure in which the first FET and the second FET are MOSFETs which are formed on a silicon substrate.

This structure reduces a cost.

A second semiconductor circuit according to the present invention is a semiconductor circuit which is formed by arranging a first FET and a second FET in series to each other between a ground and a power source, wherein the first FET includes a gate which receives a signal-to-be frequency-converted, a source and a drain, the first FET having a relatively shallow threshold value, the second FET includes a gate which receives a local oscillation signal, a source and a drain, the second FET being formed by a depression type FET, the second FET having a threshold value which is deeper than the threshold value of the first FET, the source of at least one of the first FET and the second FET which is arranged near the ground is connected to the ground, the drain of at least one of the first FET and the second FET which is arranged near the power source is connected to the power source, and the semiconductor circuit serves as a frequency conversion circuit which frequency-converts and outputs the signal-to-be frequency-converted which is received at the first FET by the local oscillation signal which is received at the second FET.

In the structure of the second semiconductor circuit, during an operation of the second FET, the resistance value of the second FET having a relatively deep threshold value is smaller than the resistance value of the first FET which has a relatively shallow threshold value. Hence, when a voltage is applied between the drain of the second FET and the source of the first FET, the power source voltage is applied to the two FETs which are connected in series to each other and which have different resistances from each other. Therefore, regardless of a positional relationship between the two FETs, a voltage which is approximately the same as the power source voltage is applied to the first FET which has a shallow threshold value. This allows to decrease the power source voltage which is necessary to operate the first FET which receives the signal-to-be frequency-converted. Further, it is possible to maintain a signal conversion gain and a third order intermodulation distortion characteristic high.

The first FET and the second FET within the second semiconductor circuit may be dual gate type FETs which have common source and drain, or the sources and the drains of the first FET and the second FET may be separate from each other.

The second semiconductor circuit may have a structure in which the source of the first FET is connected directly to the ground.

Such a structure further decrease the power source voltage.

The second semiconductor circuit may have a structure in which the threshold value of the first FET is approximately zero and the second FET is a depression type FET which has a relatively deep threshold value.

In such a structure, since the resistance of the second FET which has a deep threshold value is small, even through the first FET is disposed near the power source, a source potential of the first FET is approximately equal to the ground potential. Further, since the threshold value of the first FET which has a shallow threshold value is approximately zero, an operation current of the first FET is set by a drain current at this 0-bias point. Hence, the power source voltage as it is becomes a voltage between the drain of the FET which is near the power source and the source of the FET which is near the ground, and the power source voltage can be further decreased.

The second semiconductor circuit may further comprise a first input matching circuit which is disposed before the gate of the first FET to match signals-to-be frequency-converted; a second input matching circuit which is disposed before the gate of the second FET to match local oscillation signals; and an output matching circuit which is disposed after the drain of one of the first FET and the second FET which is disposed near the power source to match output signals.

In such a structure, since high frequency signal are matched within the semiconductor circuit, it is possible to match high frequency signals without forming a matching circuit externally to the semiconductor circuit.

The second semiconductor circuit may have a structure in which the first FET and the second FET are MESFETs which are formed on a compound semiconductor substrate.

With such a structure, it is possible to form a semiconductor circuit which has an excellent frequency characteristic.

The first FET and the second FET may be MOSFETs which are formed on a silicon substrate.

This structure reduces a cost.

The first semiconductor circuit which functions as an amplifier may be disposed before the respective FETs of the second semiconductor circuit which functions as a frequency conversion circuit.

In such a structure, combination of an amplifier and a frequency conversion circuit decreases a power source voltage for a front end circuit or the like. Further, this circuit uses less number of resistor elements than in the conventional circuit, and this circuit does not need a capacitor which uses a large area. Since these passive elements are not necessary, and therefore, the size of a chip is reduced.

BRIEF DESCRIPTION OF THE DRAWINGS

Fig. 1 is an electric circuitry diagram of an amplifier which is incorporated in a receiver circuit according to a first preferred embodiment;

Figs. 2(a) and 2(b) are views showing an $I_D$-$V_{GS}$ characteristic of each FET in the first preferred embodiment;

Fig. 3 is a view showing the power source voltage dependence of gains of a conventional amplifier and the amplifier of the present invention;

Fig. 4 is an electric circuitry diagram of a frequency convertor circuit which is incorporated in a receiver circuit according to a second preferred embodiment;

Fig. 5 is a view showing conversion gains and the power source voltage dependence of distortion characteristics of a conventional frequency convertor circuit and the frequency convertor circuit of the present invention;

Fig. 6 is an electric circuitry diagram of a frequency convertor circuit which is incorporated in a receiver circuit according to a third preferred embodiment;

Fig. 7 is an electric circuitry diagram of a front end circuit of the receiver circuit according to the third preferred embodiment;

Fig. 8 is a view showing conversion gains and the power source voltage dependence of distortion characteristics of a conventional front end circuit and the front end circuit of the present invention;

Fig. 9 is an electric circuitry diagram of a frequency convertor circuit which is incorporated in a receiver circuit which includes a conventional GaAsMESFET;

Fig. 10 diagrammatically shows operation points of a conventional frequency convertor circuit;

Fig. 11 is an electric circuitry diagram of a frequency convertor circuit which is incorporated in a receiver circuit which includes a conventional GaAsMESFET; and

Fig. 12 is a cross sectional view showing an example of modification in which a first and a second FETs of each preferred embodiment are formed by dual gate type FETs.

## DESCRIPTION OF THE PREFERRED EMBODIMENTS

First Preferred Embodiment

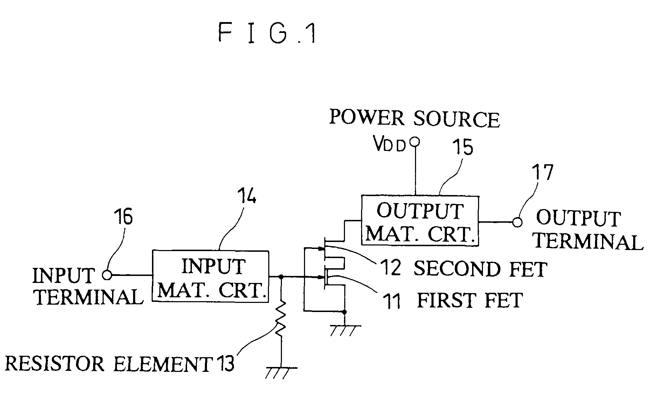

First, a first preferred embodiment will be described. Fig. 1 is an electric circuitry diagram of an amplifier which is incorporated in a receiver circuit according to the first preferred embodiment. In Fig. 1, denoted at 11 is a first FET which is formed by a depression type FET whose threshold value is relatively shallow (-0.1V in this preferred embodiment), while denoted at 12 is a second FET which is formed by a depression type FET whose threshold value is relatively deep (-0.8V in this preferred embodiment). A drain of the first FET 11 is connected to a source of the second FET 12, and a gate of the first FET 11 is grounded through a resistor element 13. The resistance value of the resistor element 13 is sufficiently larger than an input impedance of the first FET 11 (for instance, about twice the input impedance of the first FET 11).

Further, a gate of the second FET 12 is connected to a source of the first FET 11. Denoted at 16 is an input terminal for inputting a high frequency signal, and denoted at 17 is an output terminal for outputting the high frequency signal. Denoted at 14 is an input matching circuit for matching the high frequency signal at the input terminal 16 to the high frequency signal at the gate of the first FET 11, and denoted at 15 an output matching circuit for matching the high frequency signal at a drain of the second FET 12 to the high frequency signal at the output terminal 17.

In the amplifier having such a structure as described above, an input signal which is inputted to the gate of the first FET 11 through the input matching circuit 14 is amplified, and the amplified signal is outputted at the drain of the second FET 12 and eventually at the output terminal 17 through the output matching circuit 15.

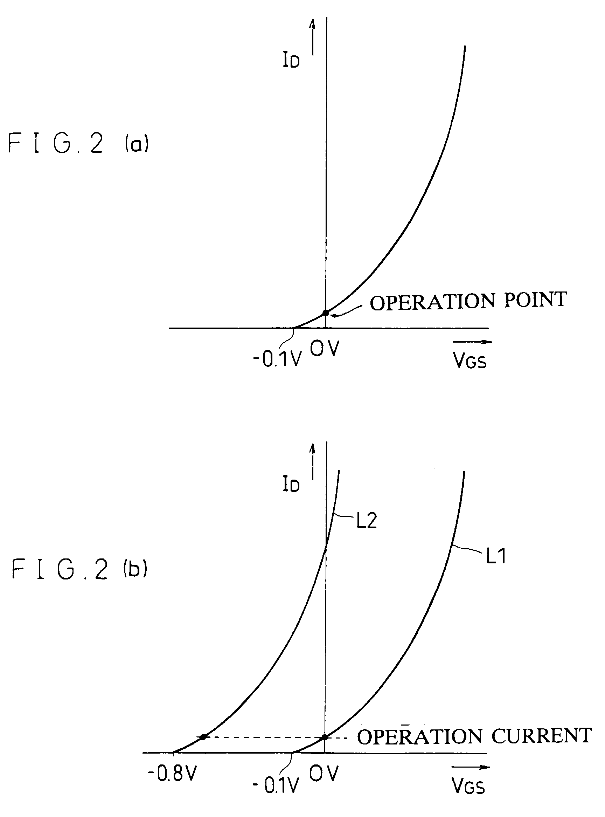

Next, operation points of the FETs during such an operation will be described with reference to Figs. 2(a) and 2(b). In Figs. 2(a) and 2(b), a horizontal axis shows the gate-source voltage $V_{GS}$, while a vertical axis shows the drain current $I_D$. As shown in Fig. 2(a), an operation point of the first FET 11 according to the first preferred embodiment is set at a 0-bias point. On the other hand, in Fig. 2(b), a curve L1 expresses the $I_D$-$V_{GS}$ characteristic of the first FET 11 while a curve L2 expresses the $I_D$-$V_{GS}$ characteristic of the second FET 12. In the present preferred embodiment, since the second FET 12 is formed by a depression type FET whose threshold value is deep, the impurity concentration is high, a depletion layer immediately under the gate is shallow, and a source-drain resistance value is extremely small. Hence, when a power source voltage $V_{DD}$ is applied between the drain of the second FET 12 and the source of the first FET 11, voltage drop after the second FET 12 is small so that the power source voltage $V_{DD}$ is applied mostly to the first FET 11 whose threshold value is shallow. This allows to decrease the power source voltage $V_{DD}$ which is necessary to operate the first FET 11, and to maintain the high gain at which the input signal to the first FET 11 is amplified.

In the present preferred embodiment, in particular, since the threshold value of the first FET 11 is almost "0" and the gate and the source of the first FET 11 are grounded, an operation current of the first FET 11 is set by the drain current $I_D$ at the 0-bias point of the first FET 11. Since this allows the power source voltage as it is to become the voltage between the drain of the second FET 12 and the source of the first FET 11, more power source voltage reduction is realized than in a structure which uses a conventional depression type FET.

Further, since the gate of the second FET 12 is directly grounded, any unnecessary signal which might flow to the gate of the first FET 11 through the second FET 12 will be bypassed to the ground via the gate of the second FET 12. In this manner, the separation characteristic which separates an output from an input is maintained excellent as in the conventional structure.

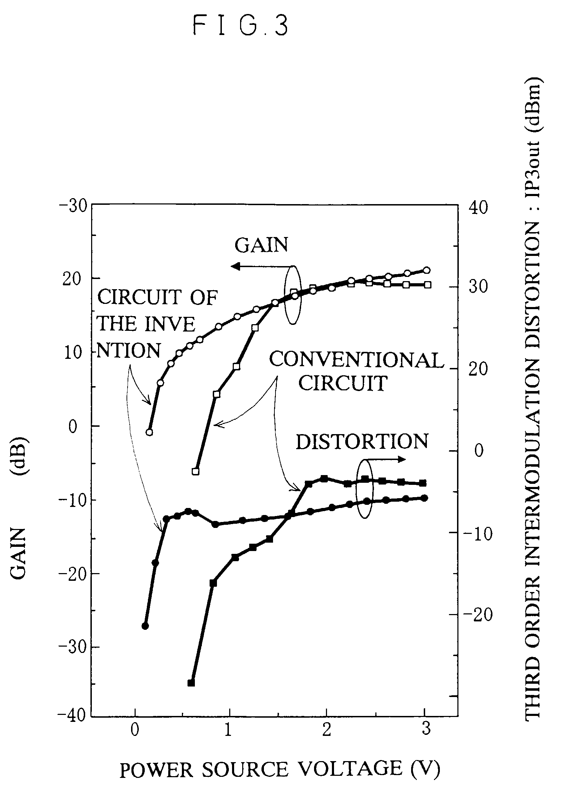

Next, an effect of the present invention will be described. Fig. 3 is a view showing the power source voltage dependence of gains and third order intermodulation distortion characteristics of a conventional amplifier which uses a dual gate FET which is formed by a conventional depression type FET and the amplifier of the present invention which has the structure of Fig. 1. The value of a third order intercept point IP3 is shown as the third order intermodulation distortion characteristics. As this value is larger, distortion is smaller and the characteristics are better. As shown in Fig. 3, in a range wherein the power source voltage is larger than about 1.5V, the gain and the third order intermodulation distortion characteristic of the conventional amplifier are somewhat better than those of the amplifier of the present invention. However, as the power source voltage becomes smaller than 1.5V, the gain and the third order intermodulation distortion characteristic of the conventional amplifier both abruptly drop, that is, the characteristics degrade. In contrast, even when the power source voltage is lowered by about 1.0V, the amplifier of the present invention can maintain a higher amplification ratio than the conventional amplifier. In other words, the amplifier of the present invention realizes power source voltage reduction of about 1.0V.

Lastly, setting of the threshold values of the first and the second FETs 11 and 12 will be described. Although the present preferred embodiment sets the threshold value of the first FET 11 as -0.1V, the absolute value of the threshold value of the second FET 12 which is a depression type FET having a deep threshold value is preferably 70% to 90% of the power source voltage. For instance, when the power source voltage is 1.0V, the threshold value of the second FET 12 is preferably around -0.7V to -0.9V. Considering this, the present preferred embodiment sets the threshold value of the second FET 12 as -0.8V. Meanwhile, the threshold value of the first FET 11 is preferably set at a point at which the operation current of this amplifier circuit approximately coincides with the operation current of the first FET 11. That is, the threshold value of the first FET 11 is preferably set so that $I_{DD} = I_{DGS}$ is satisfied where $I_{DD}$ is the operation current of the amplifier circuit and $I_{DGS}$ is the operation current of the first FET 11 ($V_{GS} = 0$).

However, the present invention is not limited to this preferred embodiment. Rather, the first and the second FETs may be formed by enhancement type FETs. When each FET is formed by an enhancement type FET, the FET having a higher threshold voltage is referred to as the FET having a shallow threshold value while the FET having a lower threshold voltage is referred to as the FET having a deep threshold value. Hence, when the first and the second FETs are each formed by an enhancement type FET, the threshold value of the first FET is set as 1.0V and the threshold value of the second FET is set as 0.1V so that a high frequency amplification circuit which is driven at a low voltage is obtained.

Alternatively, in the circuit according to this preferred embodiment, the first FET may be formed by an enhancement type FET which has a threshold value of about 0.1V and the second FET may be formed by a depression type FET which has a threshold value of about -0.9V.

In this preferred embodiment, it is beneficial for efficiently obtaining the effects of the present invention that the threshold voltages of the first FET 11 and of the second FET 12 are within the ranges between -0.3V and +0.2V and between -3.0V and -0.5V, respectively.

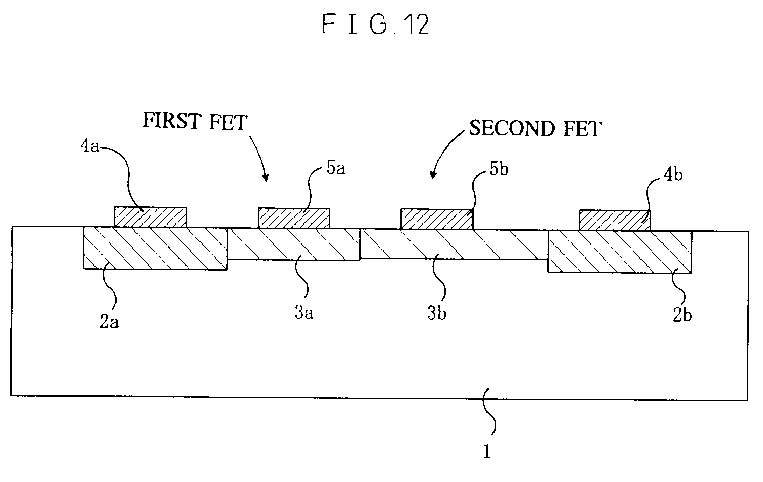

Further, it is not always necessary to form the first and the second FETs independently of each other. Fig. 12 is a cross sectional view showing a structure of a so-called dual gate type FET which is formed by a first FET and a second FET which have common source and drain. As shown in Fig. 12, in a surface region of a semiconductor substrate 1, two $n^+$ layers 2a and 2b are formed which become a common source-drain region which is common to FETs which are formed by heavily doping the substrate with an n-type impurity. Between the $n^+$ layers 2a and 2b, a first n-layer 3a and a second n-layer 3b are formed by lightly doping the substrate with an n-type impurity. A source electrode 4a and a drain electrode 4b are formed on the $n^+$ layer 2a and the $n^+$ layer 2b, respectively. A first gate electrode 5a of the first FET is formed on the first n-layer 3a, while a second gate electrode 5b of the second FET is formed on the second n-layer 3b. It is to be noted, however, when the structure of this dual gate type FET is used in this preferred embodiment, the source electrode 4a and the second gate electrode 5b are connected to each other. The first n-layer 3a is somewhat more lightly doped than the second n-layer. In other words, the threshold value of the first FET is set shallow while the threshold value of the second FET is set deep.

The first and the second FETs have approximately the same characteristics in the case of the dual gate type FET of Fig. 12 and in the case of Fig. 1 as well wherein the sources and the drains of the first and the second FETs are formed separately from each other. Hence, even when a dual gate type FET is formed by the first and the second FETs, the circuitry structure remains the same in that the source of the first FET is connected to the gate of the second FET and in other points, and the circuit exhibits the same effect as that realized in the first preferred embodiment as far as the threshold values of the FETs are the same as those of the FETs according to the first preferred embodiment.

Second Preferred Embodiment

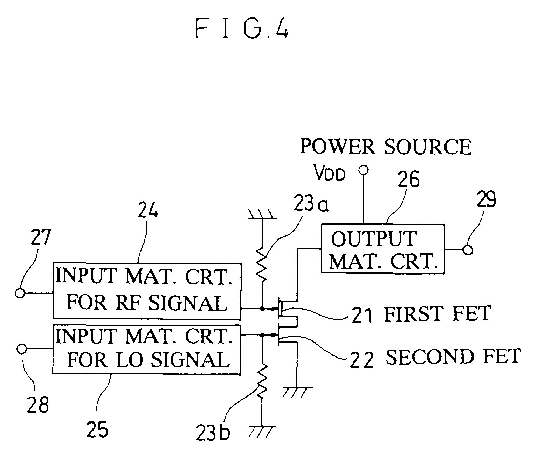

Next, a second preferred embodiment will be described. Fig. 4 is an electric circuitry diagram showing a structure of a frequency convertor circuit which is incorporated in a receiver circuit according to the second preferred embodiment.

In Fig. 4, denoted at 21 is a first FET which is formed by a depression type FET whose threshold value is shallow, and denoted at 22 is a second FET which is formed by a depression type FET whose threshold value is deep. Gates of the FETs 21 and 22 are grounded through resistor elements 23a and 23b, respectively. Further, denoted at 27 and 28 are a first and a second input terminals for inputting a signal-to-be frequency-converted (RF signal in the figure) and a local oscillation signal (LO signal in the figure), respectively, while denoted at 29 is an output terminal for outputting a high frequency signal. Denoted at 24 is an input matching circuit for signal-to-be frequency-converted, which matches signals which are to be frequency-converted between the first input terminal 27 and a gate of the first FET 21. Denoted at 25 is an input matching circuit for local oscillation signal, which matches local oscillation signals between the second input terminal 28 and a gate of the second FET 22. Denoted at 26 is an output matching circuit for matching high frequency signals between a drain of the first FET 21 and the output terminal 29.

In the following, an operation of the frequency conversion circuit having such a structure as above will be described. A signal-to-be frequency-converted which is inputted at the first input terminal 27 is supplied to the first FET 21 through the input matching circuit for signal-to-be frequency-converted 24. On the other hand, a local oscillation signal which is inputted at the second input terminal 28 is supplied to the second FET 22 through the input matching circuit for local oscillation signal 25. In the frequency conversion circuit, the signal-to-be frequency-converted is frequency-converted by the local oscillation signal, and this frequency-converted signal is outputted at the drain of the first FET 21 and thereafter outputted at the output terminal 29 through the output matching circuit 26. For understanding of the process of frequency conversion, the second FET 22 is considered as a variable resistor element which is connected between the source of the first FET 21 and the ground. In short, by means of the local oscillation signal, the resistance value of the second FET 22 (variable resistor element) is variably controlled. For example, when the resistance value of the variable resistor element is large, the first FET 21 does not carry a current so that a signal is not outputted to the output terminal 29. On the other hand, when the resistance value of the variable resistor element is small, the first FET 21 carries a current so that a signal is outputted to the output terminal 29. The process is understood easier if frequency conversion is grasped in this manner. The gain in the frequency conversion circuit is controlled by the resistance value of the second FET 22 which is a variable resistor element, and the resistance value of this variable resistor element is controlled by the amplification of the local oscillation signal. That is, as the amplification of the local oscillation signal is larger, the width of expansion and reduction of the depletion layer immediately under the gate of the second FET becomes larger, and therefore, the source-drain current flows more easily so that the resistance value becomes small.

During such an operation of the frequency conversion circuit, an operation point is set by a current at a 0-bias point of the depression type FET whose threshold value is small, i.e., the first FET 21, as in the first preferred embodiment. This allows the power source voltage as it is to become the voltage between the drain of the first FET 21 and the source of the second FET 22, and to decrease the power source voltage.

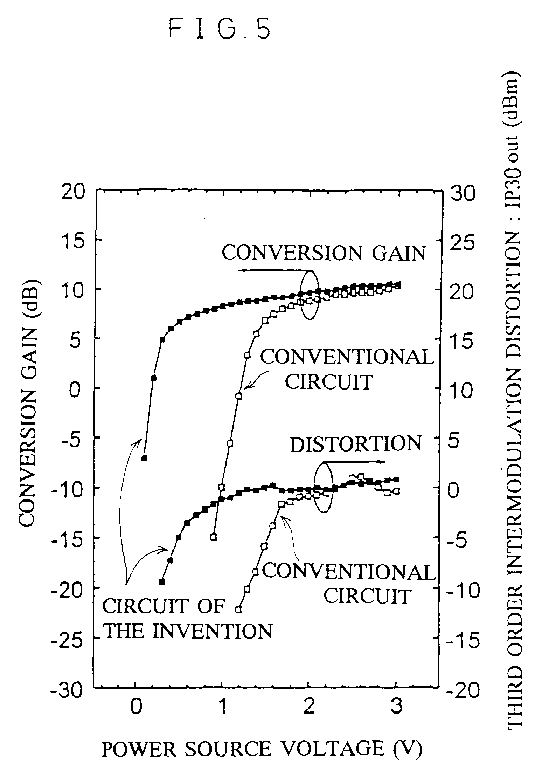

Next, Fig. 5 shows conversion gains and the power source voltage dependence of third order intermodulation distortion characteristics of a conventional frequency conversion circuit which uses a dual gate type FET which is formed by a depression type FET whose threshold value is deep and the frequency conversion circuit of the present invention which has the structure of Fig. 4. Like the data of the first preferred embodiment, the third order intermodulation distortion characteristics are expressed by the value of a third order intercept point IP3. As shown in Fig. 5, the frequency conversion circuit of the present invention can maintain an excellent conversion gain and an excellent distortion characteristic even when the power source voltage is lowered by about 1.0V than in the conventional circuit. In other words, the frequency conversion circuit of the present invention realizes power source voltage reduction of about 1.0V.

To attain the effect of the present invention efficiently, in this preferred embodiment, the threshold voltages of the first FET 21 and the second FET 22 are preferably within the ranges between -3.0V and -0.5V and between -0.3V and +0.2V, respectively.

In this preferred embodiment as well, each FET may be formed by a dual gate type FET as that shown in Fig. 12. Further, the first FET of this preferred embodiment may be formed by an enhancement type FET.

Third Preferred Embodiment

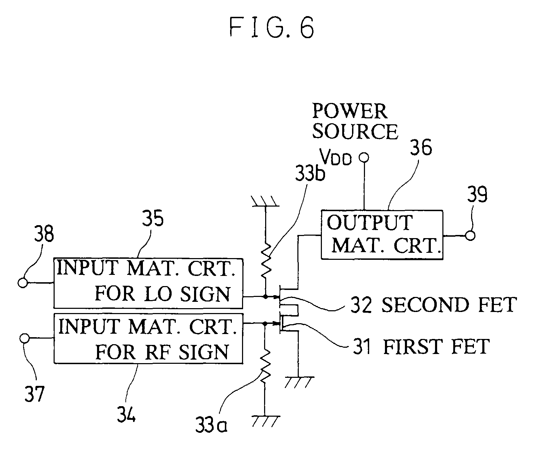

Next, a third preferred embodiment will be described. Fig. 6 is an electric circuitry diagram showing a structure of a frequency convertor circuit which is incorporated in a receiver circuit according to the third preferred embodiment.

The structure of the frequency conversion circuit shown in Fig. 6 is equivalent to that of the second preferred embodiment as it is modified to replace the positions of the FETs. That is, a drain of a first FET 31 which is formed by a depression type FET whose threshold value is shallow is connected to a source of a second FET 32 which is formed by a depression type FET whose threshold value is deep, and a source of the first FET 31 is directly grounded. An output matching circuit 39 is disposed between a drain of the second FET 32 and an output terminal 39. The structure of the third preferred embodiment is otherwise similar to that of the second preferred embodiment.

An operation of the frequency conversion circuit which has such a structure as described above is basically the same as the operation in the second preferred embodiment. In short, a signal-to-be frequency-converted which is inputted at a first input terminal 37 is frequency-converted by a local oscillation signal which is inputted at a second input terminal 38, and this frequency-converted signal is outputted at the drain and thereafter outputted to outside at the output terminal 39 through the output matching circuit 36.

In this preferred embodiment as well, an operation point is set by a current at a 0-bias point of the first FET 31 which is a depression type FET whose threshold value is shallow, as in the first preferred embodiment. For understanding of the process of frequency conversion, the second FET 32 is considered as a variable resistor element which is connected between the drain of the first FET 31 and the output terminal 39. That is, by means of the local oscillation signal, the resistance value of the second FET 32 (variable resistor element) is variably controlled. For example, when the resistance value of the variable resistor element is large, the first FET 31 does not carry a current so that a signal is not outputted to the output terminal 39. On the other hand, when the resistance value of the variable resistor element is small, the first FET 31 carries a current so that a signal is outputted to the output terminal 39. The process is understood easier if frequency conversion is grasped in this manner. The gain in the frequency conversion circuit is controlled by the resistance value of the second FET 32 which is a variable resistor element, and the resistance value of this variable resistor element is controlled by the amplification of the local oscillation signal.

Thus, in this preferred embodiment as well, it is possible to decrease the power source voltage while maintaining an excellent conversion gain and an excellent distortion characteristic, as in the second preferred embodiment.

In this preferred embodiment, it is beneficial for efficiently obtaining the effects of the present invention that the threshold voltages of the first FET 31 and of the second FET 32 are within the ranges between -3.0V and -0.5V and between -0.3V and +0.2V, respectively.

In this preferred embodiment as well, each FET may be formed by a dual gate type FET. Further, the first FET of this preferred embodiment may be formed by an enhancement type FET.

Fourth Preferred Embodiment

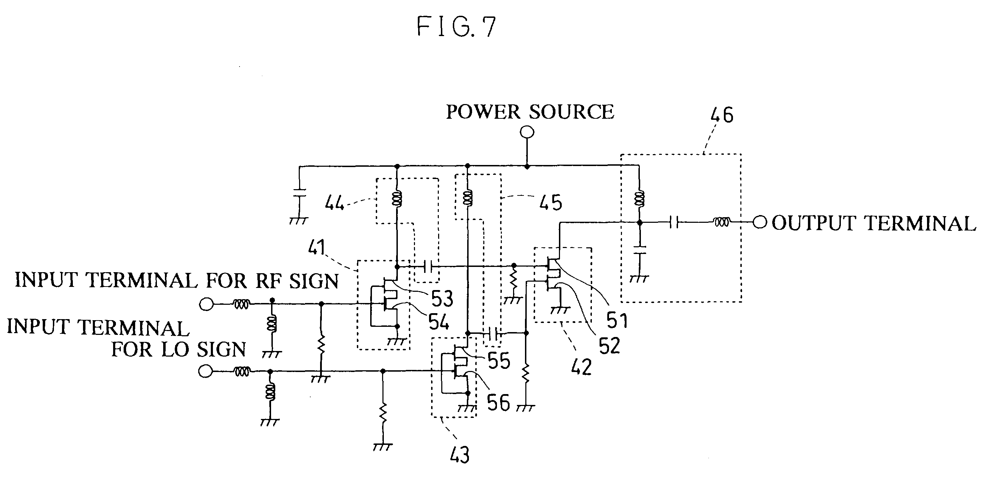

Next, a fourth preferred embodiment will be described. Fig. 7 is an electric circuitry diagram of a front end circuit which is disposed in a receiver circuit according to the fourth preferred embodiment.

In Fig. 7, denoted at 41 and 43 are a first and a second amplification circuits each having a structure which is similar to that used in the first preferred embodiment, and denoted at 42 is a frequency conversion circuit which has a structure which is similar to that in the second preferred embodiment. Denoted 44 and 45 are a first interstage and a second interstage matching circuits. Denoted at 46 an output matching circuit.

As in the second preferred embodiment, the frequency conversion circuit 42 is formed by connecting a source of a depression type first FET 51 having a shallow threshold value to a drain of a depression type second FET 52 having a deep threshold value. A gate of the first FET 51 is connected to an input terminal for signal-to-be frequency-converted through the first amplification circuit 41, while a drain of the first FET 51 is connected to an output terminal through the output matching circuit 46. A gate of the second FET 52 is connected to an input terminal for local oscillation signal through the second amplification circuit 43, while a source of the second FET 52 is directly grounded.

As in the first preferred embodiment, the first amplification circuit 41 is formed by connecting a drain of a depression type third FET 53 having a shallow threshold value to a source of a depression type fourth FET 54 having a deep threshold value. The second amplification circuit 42 is formed by connecting a drain of a depression type fifth FET 55 having a shallow threshold value to a source of a depression type sixth FET 56 having a deep threshold value, as in the first preferred embodiment. A drain of the third FET 53 which is disposed within the first amplification circuit 41 is connected to a gate of the first FET 51 which is disposed within the frequency conversion circuit 42 and to the power source through the first interstage matching circuit 44. A drain of the fifth FET 55 which is disposed within the second amplification circuit 42 is connected to a gate of the second FET 52 which is disposed within the frequency conversion circuit 42 and to the power source through the second interstage matching circuit 45.

Now, an operation of the front end circuit above will be described. A signal which is inputted at the input terminal for signal-to-be frequency-converted is supplied to the gate of the first FET 51 which is disposed within the frequency conversion circuit 42, through the first amplification circuit 41 and the first interstage matching circuit 44. On the other hand, a signal which is inputted at the input terminal for local oscillation signal is supplied to the gate of the second FET 52 which is disposed within the frequency conversion circuit 42, through the second amplification circuit 42 and the second interstage matching circuit 45. In the frequency conversion circuit 42, a signal-to-be frequency-converted is frequency-converted by a local oscillation signal and this frequency-converted signal is outputted at the output terminal through the output matching circuit 46.

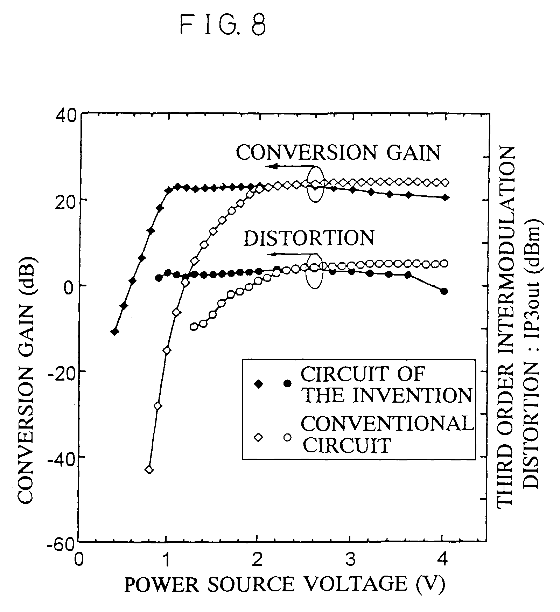

Fig. 8 shows conversion gains and the power source voltage dependence of third order intermodulation distortion characteristics of a conventional front end circuit which includes a dual gate type FET which is formed by a depression type FET whose threshold value is deep and the front end circuit of the present invention which has the structure of Fig. 7. As in the second preferred embodiment, the third order intermodulation distortion characteristics are expressed by the value of a third order intercept point IP3. The front end circuit of the present invention realizes power source voltage reduction of about 1.0V, as compared in the conventional front end circuit.

In addition, the circuit of the present invention uses less number of resistor elements than in the conventional circuit, and the circuit of the present invention does not need a capacitor which uses a large area. For instance, the source of the fourth FET 54 of the first amplification circuit 41, the source of the sixth FET 56 of the second amplification circuit 43, the source of the second FET 52 of the frequency conversion circuit 42 which are shown in Fig. 7 are directly grounded. Hence, it is not necessary to use the resistor element 112 and the capacitor 113 which are included in the conventional circuit shown in Fig. 11. Since these passive elements are not necessary, and therefore, the size of a chip is reduced.

While the elements are formed by GaAsMESFETs in the first to the fourth preferred embodiments, the elements may be formed by silicon MOSFETs. This is because a high frequency signal can pass through between the gate and the source in this structure as well.

## Claims

1. A semiconductor circuit which is formed by arranging a first FET and a second FET between a ground and a power source in series to each other in this order from the ground, wherein

said first FET includes a gate which receives an input signal, a source which is connected to the ground, and a drain, said first FET having a relatively shallow threshold value,
said second FET includes a gate which is connected to a source of said second FET, the source, and a drain which is connected to said power source to serve as a signal output part, said second FET having a threshold value which is deeper
than the threshold value of said first FET, and said semiconductor circuit serves as an amplifier which amplifies a signal which is inputted at the gate of said first FET and outputs the signal at the drain of said second FET.

2. The semiconductor circuit of Claim 1, wherein said first FET and said second FET form a dual gate type FET, said dual gate type FET having a common source and a common drain, which are formed by implanting an impurity into a semiconductor substrate, on said semiconductor substrate, the gate of said first FET and the gate of said second FET being disposed in this order from said source between said common source and said common drain, and
said common source of said dual gate type FET is connected to said ground while said common drain of said dual gate type FET is connected to said power source.

3. The semiconductor circuit of Claim 1, wherein said first FET and said second FET have sources and drains separately from each other which are formed by implanting an impurity into a semiconductor substrate, and
the drain of said first FET and the source of said second FET are connected to each other.

4. The semiconductor circuit of Claim 1, wherein the source of said first FET is connected directly to said ground.

5. The semiconductor circuit of Claim 4, wherein a threshold value of said first FET is approximately zero, and
said second FET is a depression type FET whose threshold value is relatively deep.

6. The semiconductor circuit of Claim 1, wherein the gate of said first FET is connected to said ground through a resistor.

7. The semiconductor circuit of Claim 1, further comprising:

an input matching circuit which is disposed before the gate of said first FET to match input signals; and
an output matching circuit which is disposed after the drain of said second FET to match output signals.

8. The semiconductor circuit of Claim 1, wherein said first FET and said second FET are MESFETs which are formed on a compound semiconductor substrate.

9. The semiconductor circuit of Claim 1, wherein said first FET and said second FET are MOSFETs which are formed on a silicon substrate.

10. A semiconductor circuit which is formed by arranging a first FET and a second FET in series to each other between a ground and a power source, wherein

said first FET includes a gate which receives a signal-to-be frequency-converted, a source and a drain, said first FET having a relatively shallow threshold value,
said second FET includes a gate which receives a local oscillation signal, a source and a drain, said second FET being formed by a depression type FET, said second FET having a threshold value which is deeper than the threshold value of said first FET,
the source of at least one of said first FET and said second FET which is arranged near said ground is connected to said ground,
the drain of at least one of said first FET and said second FET which is arranged near said power source is connected to said power source, and
said semiconductor circuit serves as a frequency conversion circuit which frequency-converts and outputs said signal-to-be frequency-converted which is received at said first FET by said local oscillation signal which is received at said second FET.

11. The semiconductor circuit of Claim 10, wherein said first FET and said second FET form a dual gate type FET, said dual gate type FET having a common source and a common drain, which are formed by implanting an impurity into a semiconductor substrate, on said semiconductor substrate, the gate of said first FET and the gate of said second FET being disposed in this order from said source side between said common source and said common drain, and
said common source of said dual gate type FET is connected to said ground while said common drain of said dual gate type FET is connected to said power source.

12. The semiconductor circuit of Claim 10, wherein said first FET and said second FET have sources and drains separately from each other which are formed by implanting an impurity into a semiconductor substrate, and

    the drain of one of said FETs and the source of the other one of said FETs are connected to each other.

13. The semiconductor circuit of Claim 10, wherein the source of one of said FETs is connected directly to said ground.

14. The semiconductor circuit of Claim 13, wherein a threshold value of said first FET is approximately zero, and

    said second FET is a depression type FET whose threshold value is relatively deep.

15. The semiconductor circuit of Claim 10, further comprising:

    a first input matching circuit which is disposed before the gate of said first FET to match signals-to-be frequency-converted;
    a second input matching circuit which is disposed before the gate of said second FET to match local oscillation signals; and
    an output matching circuit which is disposed after the drain of one of said first FET and said second FET which is disposed near said power source to match output signals.

16. The semiconductor circuit of Claim 10, wherein said first FET and said second FET are MESFETs which are formed on a compound semiconductor substrate.

17. The semiconductor circuit of Claim 10, wherein said first FET and said second FET are MOSFETs which are formed on a silicon substrate.

18. The semiconductor circuit of Claim 10, further comprising:

    a first amplifier which is disposed before the gate of said first FET to amplify said signal-to-be frequency-converted;
    a first interstage matching circuit to match a signal between said first amplifier and the gate of said first FET;
    a second amplifier which is disposed before the gate of said second FET to amplify said local oscillation signal; and
    a second interstage matching circuit to match a signal between said second amplifier and the gate of said second FET, wherein
said first amplifier is formed by:

    a third FET which includes a gate for receiving said signal-to-be frequency-converted, a source which is connected to said ground, and said drain, a threshold value of said third FET being relatively shallow; and
    a fourth FET which includes a gate which is connected to the source of said third FET, a source, and a drain which is connected to said power source and the gate of said first FET, a threshold value of said fourth FET being deeper than the threshold value of said third FET, and
    said second amplifier is formed by:

    a fifth FET which includes a gate for receiving said local oscillation signal, a source which is connected to said ground, and a drain, a threshold value of said fifth FET being relatively shallow; and
    a sixth FET which includes a gate which is connected to the source of said fifth FET, a source, and a drain which is connected to said power source and the gate of said second FET, a threshold value of said sixth FET being deeper than the threshold value of said fifth FET.

# F I G .1

POWER SOURCE

V_DD 15

17

16 14

INPUT
TERMINAL

INPUT
MAT. CRT.

OUTPUT
MAT. CRT.

OUTPUT
TERMINAL

12 SECOND FET

11 FIRST FET

RESISTOR ELEMENT 13

F I G. 2 (a)

OPERATION POINT

-0.1V 0V

I$_D$

V$_{GS}$

F I G. 2 (b)

L2

L1

OPERATION CURRENT

-0.8V   -0.1V 0V

I$_D$

V$_{GS}$

# F I G.3

# F I G.4

POWER SOURCE

# F I G . 5

# FIG. 6

# FIG.7

POWER SOURCE

INPUT TERMINAL FOR RF SIGN

INPUT TERMINAL
FOR LO SIGN

OUTPUT TERMINAL

44
45
46
41
53
54
55
56
51
52
42
43

EP 0 805 551 A1

# F IG. 8

FIG. 9 PRIOR ART

POWER SOURCE

FIG. 10   PRIOR ART

FIG. 11 PRIOR ART

# F I G.12

FIRST FET

SECOND FET

4a

5a

5b

4b

2a

3a

3b

2b

1

European Patent
Office

**EUROPEAN SEARCH REPORT**

Application Number

EP 96 10 6855

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP 0 176 754 A (SUMITOMO ELECTRIC INDUSTRIES LTD.)<br>* figure 9 *<br>* page 15, line 20 - page 16, line 2 * | 1,18 | H03F3/193 |
| A | *Idem* | 3,4,8,<br>12,13,16 | |
| | --- | | |
| Y | EP 0 587 136 A (SUMITOMO ELECTRIC INDUSTRIES LTD.)<br>* figure 7 *<br>* column 7, line 6 - line 23 * | 1,18 | |
| | --- | | |
| A | US 5 083 050 A (VASILE)<br>* abstract; figure 2 *<br>* column 2, line 23 - line 38 * | 10 | |
| | --- | | |
| A | PATENT ABSTRACTS OF JAPAN<br>vol. 8, no. 99 (E-243), 10 May 1984<br>& JP 59 017708 A (TOKYO SHIBAURA DENKI KK.), 30 January 1984,<br>* abstract * | 10,11 | |
| | ----- | | TECHNICAL FIELDS SEARCHED (Int.Cl.6) |
| | | | H03F<br>H01L<br>H03D |

The present search report has been drawn up for all claims

| Place of search | Date of completion of the search | Examiner |
|---|---|---|
| BERLIN | 27 August 1996 | DANIELIDIS S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)